# EUROPÄISCHE PATENTSCHRIFT

(11) **EP 1 125 409 B1**
(45) Veröffentlichungstag und Bekanntmachung des Hinweises auf die Patenterteilung: **24.03.2004**
(21) Anmeldenummer: 99971982.6
(22) Anmeldetag: 21.10.1999
(51) Int. Cl.: H04L 27/26, H04L 1/24

(54) **VERFAHREN ZUR MESSTECHNISCHEN AUSWERTUNG VON MULTITRÄGER-SIGNALEN**
METHOD FOR MEASURING AND EVALUATING MULTI-CARRIER SIGNALS
PROCEDE D'EVALUATION DE SIGNAUX A PORTEUSES MULTIPLESAR TECHNIQUES DE MESURE

(30) Priorität: 05.11.1998 DE 19851093
(43) Veröffentlichungstag der Anmeldung: 22.08.2001
(73) Patentinhaber: Rohde & Schwarz GmbH & Co. KG, D-81671 München (DE)
(72) Erfinder: WOLF, Peter, D-81543 München (DE); BALZ, Christoph, D-81543 München (DE)
(74) Vertreter: Körfer, Thomas, Dipl.-Phys.
(86) Internationale Anmeldenummer: PCT/EP1999/008006
(87) Internationale Veröffentlichungsnummer: WO 2000/028711

(56) Entgegenhaltungen:
- EP-A- 0 781 014
- US-A- 4 818 931
- Using Vector Modulation Analysis in the Integration Troubleshooting and Design of digital RF Communications Systsems. Product note HP 89400-8 Hewlett and Packard, U.S.A. January 1994 XP002130914

## Beschreibung

Die Erfindung betrifft ein Verfahren laut Oberbegriff des Hauptanspruches.

Für die in der modernen Übertragungstechnik beispielsweise bei DAB (Digital Audio Broadcasting) bzw. DVB-T (Digital Video Broadcasting, terrestrial) benutzten OFDM (Orthogonal Frequency Division Multiplex)-Multiträger-Systeme ist für eine meßtechnische Auswertung eine graphische Darstellung wünschenswert, die es einem Anwender ermöglicht, auf einen Blick Fehler des Systems zu erkennen. Es ist zwar bekannt, die digitale Modulation eines einzigen Trägers mit kombinierter Umtastung zwischen Amplituden- und/oder Phasenzuständen im Vektordiagramm (I/Q-Ebene) auf dem Bildschirm einer Anzeigeeinrichtung graphisch darzustellen (deutsche Offenlegungsschrift 195 47 896), jedoch ist diese für einen einzigen Träger vorgesehene Möglichkeit für ein Multiträgersystem mit beispielsweise 1536 einzelnen Trägern bei DAB bzw. 1705 oder 6817 einzelnen Trägern bei DVB nicht mehr sinnvoll, da hier eine selektive Beurteilung des Signals nur auf sehr komplizierte Weise möglich ist.

Es ist daher Aufgabe der Erfindung, ein einfaches Verfahren aufzuzeigen, mit dem die I/Q-Komponenten eines OFDM-Signals zur meßtechnischen Auswertung für jeden einzelnen Träger getrennt graphisch dargestellt werden können.

Diese Aufgabe wird ausgehend von einem Verfahren laut Oberbegriff des Hauptanspruches durch dessen kennzeichnende Merkmale gelöst. Vorteilhafte Weiterbildungen ergeben sich aus den Unteransprüchen.

Gemäß der Erfindung werden die I-Komponenten bzw. Q-Komponenten einer frei wählbaren Anzahl von Symbolen entweder einzeln oder gemeinsam erfaßt und dann für jeden einzelnen Träger des Multiträgersignals auf dem Bildschirm einer Anzeigeeinrichtung graphisch auf einer vertikalen Linie dargestellt. Auf diese Weise kann ein Betrachter auch für ein solches Multiträgersystem sofort feststellen, ob auf einem oder mehreren Trägern überhaupt Symbole übertragen werden. Bei fehlenden I/Q-Werten entsteht nämlich in der Spalte an der Stelle des jeweiligen Trägers eine Lücke. Wenn bei einem oder mehreren Trägern gestörte Symbole oder überhaupt keine Symbole sondern nur Rauschen übertragen wird, so wird dies durch eine vertikale, durchgängige Linie in den Zeilen sichtbar. Der Benutzer erhält also eine einfache graphische Übersicht über die Ausnutzung des Wertebereiches der 1 und Q-Komponenten als Funktion der Frequenz und kann so ein solches OFDM-Multiträger-System auf einfache Weise meßtechnisch erfassen.

Die Erfindung wird im Folgenden anhand einer schematischen Zeichnung an einem Ausführungsbeispiel für ein Multiträger-Signal im 8k-Modus mit einer 16 QAM-Modulation näher erläutert.

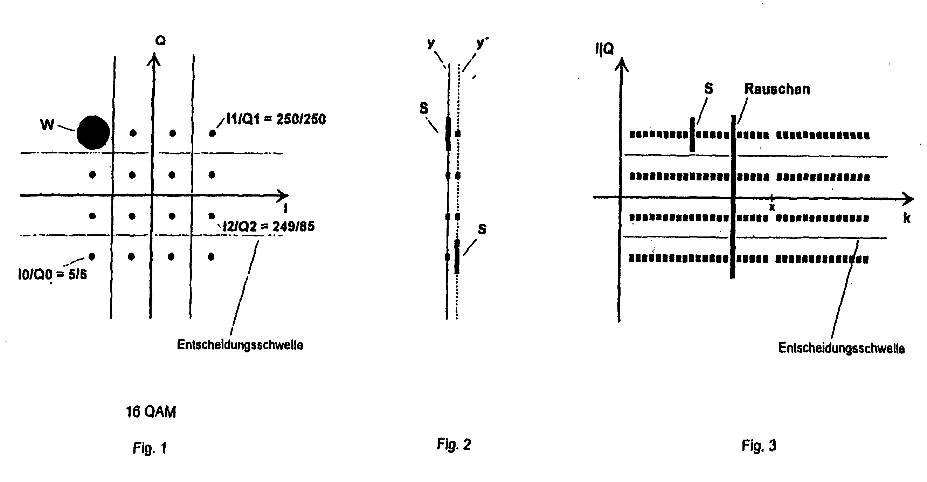

Fig. 1 zeigt das Konstellationsdiagramm für eine 16-QAM-Modulation. In einem Rechner werden all diese einzelnen Modulationspunkte des zweidimensionalen Diagramms auf die Ordinate y projiziert, wie dies Fig. 2 zeigt. Dies wird für jeden einzelnen Träger des Multiträgersystems durchgeführt und dann werden gemäß Fig. 3 die jeweiligen auf eine vertikale Linie projizierten I- und Q-Komponenten für jeden Träger einzeln auf dem Bildschirm dargestellt. Dadurch entstehen auf dem Bildschirm jeweils horizontal nebeneinander in Zeilen übereinanderliegende Punkte, die für jeden Träger den jeweiligen I/Q-Wert darstellen. Wenn auf einem Träger kein Symbol übertragen wird, so wird dies bei dem jeweiligen Träger durch fehlende Meßpunkte als Lücken dargestellt, wie dies in Fig. 3 für den Träger x dargestellt ist. Wenn durch eine Störung einer der Modulationspunkte gestört ist, wie dies durch die Wertewolke W in Fig. 1 dargestellt ist, so macht sich dies durch einen über das Entscheidungsfeld durchgängigen vertikalen Strich S bei dem jeweiligen Träger bemerkbar. Wird über einen der Träger nur Rauschen übertragen, so wird dies im Diagramm nach Fig. 3 durch eine durchgehende vertikale Linie dargestellt. Der Benutzer hat also so die Möglichkeit, die Arbeitsweise eines OFDM-Multiträger-Systems meßtechnisch zu annalysieren.

Die Abszisse des Diagramms nach Fig. 3 ist mit den Nummern k der einzelnen Träger des Multiträgersystems skaliert, bei DVB-T mit insgesamt 6817 Trägern also von 0 bis 6816 (8k-Mode). Eine derart große Anzahl von Trägern kann in manchen Fällen nicht mehr mit ausreichender Auflösung auf dem Bildschirm einer Anzeigeeinrichtung dargestellt werden. Ein in der Praxis üblicher Bildschirm ermöglicht beispielsweise in horizontaler Richtung nur eine Darstellung über 320 Spalten. In diesen Fällen ist es zweckmäßig, das gesamte Trägerspektrum in einzelne Abschnitte aufzuteilen und jeweils nur die Einzelabschnitte auf dem Bildschirm darzustellen oder die Daten mehrerer Träger zu einer Gruppe zusammenzufassen und die Daten dieser Gruppe in einer Spalte des Bildschirms darzustellen.

Wenn im Sinne des Ausführungsbeispiels alle I- und Q-Komponenten jeweils auf eine gemeinsame Linie y projiziert werden, so ist nicht erkennbar, ob eine festgestellte Störung nun vom I- oder Q-Wert oder von der Kombination dieser beiden Werte herrührt. Es ist daher vorteilhaft, eine Umschalteinrichtung vorzusehen, mit der wahlweise entweder nur alle integrierten I-Komponenten oder nur alle integrierten Q-Komponenten bzw. kombiniert alle I/Q-Komponenten für jeden Träger darstellbar sind. Eine andere Möglichkeit ist, daß die I- und Q-Komponenten jeweils auf eng nebeneinanderliegenden vertikalen Linien getrennt projiziert werden, die dann auch im Diagramm nach Fig. 3 entsprechend für jeden Träger gesondert dargestellt werden. Dies ist für Multiträgersysteme mit beispielsweise nur 100 Trägem sinnvoll und möglich. Die I-Komponenten werden also beispielsweise auf die in Fig. 2 gestrichelt eingezeichnete Linie Y' projiziert, die Q-Komponenten auf die unmittelbar daneben dargestellte vertikale Linie Y.

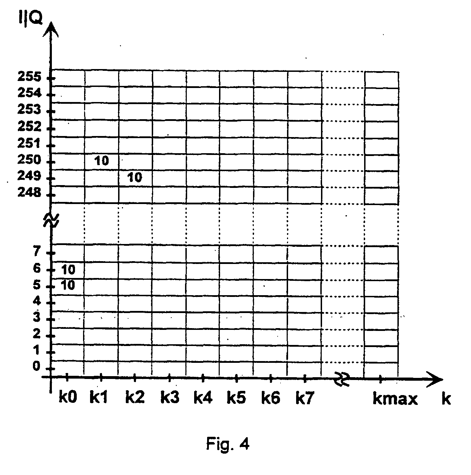

Fig. 4 zeigt schematisch ein Ausführungsbeispiel für die Integration und Linienprojektion der I- und Q-Werte der einzelnen Träger für ein einziges Symbol innerhalb eines OFDM-Signals. Benutzt dazu wird ein zweidimensionales Array (Matrixspeicher), die eine Dimension dieses Matrixspeichers entspricht den einzelnen Trägern 0...Kₘₐₓ des OFDM-Signals bzw. von Trägergruppen g, zu denen nebeneinanderliegende Einzelträger k1 bis k2 zusammengefaßt sind, um Speicherplatz zu sparen. Die Anzahl der Speicherzellen für diese Dimension des Matrixspeichers ist bestimmt durch die Anzahl von Spalten des verwendeten Displays, z.B. 320.

Die andere Dimension des Matrixspeichers ist für die I- bzw. Q-Werte reserviert. Dabei wird für jeden möglichen Zustand von I- bzw. Q innerhalb des Zustandsdiagramms der verwendeten Modulationsart eine eigene Speicherzelle vorgesehen, im Falle einer 8Bit-Kodierung der I- bzw. Q-Werte sind also 2⁸ = 256 Speicherzellen für diese Dimension des Matrixspeichers vorgesehen. Die jeweiligen I- und Q-Werte entstehen durch komplexe Demodulation der einzelnen Träger, sie sind immer bezogen auf einen einzelnen Träger k und auf ein einziges Symbol innerhalb des OFDM-Signals, ein Symbol ist bestimmt durch die Gesamtheit aller Träger zum Zeitpunkt t.

In diesen aus beispielsweise 256 Zeilenadressen und 320 Spaltenadressen bestehenden Matrixspeicher werden die demodulierten IQ-Werte eingelesen.

Zu Beginn wird der Matrixspeicher einmalig mit Nullen initialisiert.

Innerhalb eines aktuellen Symbols werden folgende Schritte durchgeführt:

### Schritt 1:

Für den ersten Träger k0 werden die zugehörigen I- und Q-Werte 10 und Q0 ermittelt und in die durch die I0-Komponente adressierte Speicherzelle wird ein vorbestimmter Haltewert, beispielsweise ein Wert 10, eingeschrieben. Dieser Haltewert bestimmt, wie lange ein Pixel in der Anzeige sichtbar sein soll. Anschließend wird in der der Q0-Komponente entsprechenden Zeilenadresse ebenfalls dieser Haltewert eingeschrieben.

### Schritt 2:

Dann wird für den nächsten Träger Schritt 1 wiederholt und in der zugehörigen Spaltenadresse k1 wird wieder in den Zeilenadressen, die den jeweiligen I1- bzw. Q1-Werten des Trägers k1 entsprechen, der entsprechende Haltewert eingeschrieben.

### Schritt 3:

Die Schritte 1 und 2 werden so lange wiederholt, bis alle Träger im ausgewählten Intervall, dessen Grenzen vom Anwender beliebig gewählt werden können, bzw. das gesamte Symbol erfaßt ist.

### Schritt 4:

Auf diese Weise wird eine vorbestimmte einstellbare Anzahl von Symbolen in den Speicher eingelesen und nach Ablauf einer vorgegebenen Erfassungszeit erfolgt zur graphischen Darstellung die Auslesung der einzelnen Spalten aus dem Matrixspeicher. Das Beschreiben der Anzeigeeinrichtung geschieht durch Abfragen des Inhaltes aller Komponenten des Speichers. Ist der Inhalt von Null verschieden, wird das entsprechende Pixel gesetzt und der Inhalt dieser Speicherzelle wird um eins dekrementiert.

Das Einschreiben eines Haltewertes unter der jeweiligen Zeilenadresse in die zugehörigen Speicherzellen hat den Vorteil, daß die Bildschirmanzeige ständig aktualisiert wird, weil mit jedem Zyklus immer neue I- und Q-Werte verarbeitet werden. Der Bildschirm hat also ein dynamisches Verhalten, auch wenn ein einzelner I/Q-Wert statisch über beliebig viele Auffrischzyklen am Bildschirm erhalten bleibt. Wenn in dem gezeigten Beispiel der Haltewert 10 gewählt wird, wird nach zehnmaligem Ausführen des Verfahrensschrittes 4 der Inhalt der Speicherzelle Null und damit angezeigt, daß in den vergangenen zehn Auffrischungen dieser I/Q-Wert nicht mehr aufgetreten ist.

Bei einer Zusammenfassung einzelner Träger zu einer Trägergruppe werden die oben beschriebenen Verfahrensschritte für alle Träger einer Gruppe so lange wiederholt, bis alle Träger einer Gruppe analysiert sind. Dann wird der Speicher für die nächste Trägergruppe adressiert.

## Patentansprüche

1. Verfahren zur meßtechnischen Auswertung von Multiträger-Signalen,
**dadurch gekennzeichnet,**
**daß** die durch Demodulation gewonnenen I- und/oder Q-Komponenten über mehrere Werte integriert und für jeden einzelnen Träger oder zusammengefaßte Trägergruppe des Multiträgersignals auf dem Bildschirm einer Anzeigeeinrichtung graphisch dargestellt werden, indem auf der horizontalen Achse eines Diagramms die einzelnen Träger oder Trägergruppen nebeneinander aufgetragen werden und längs einer vertikalen Linie jeweils die diesen Trägern oder Trägergruppen zugehörigen I- und/oder Q-Komponenten aufgezeichnet werden.

2. Verfahren nach Anspruch 1,
**dadurch gekennzeichnet,**
**daß** die jedem einzelnen Träger oder Trägergruppe zugehörigen I- und Q-Komponenten auf eine einzige vertikale Linie projiziert sind, so daß die I- und Q-Komponenten für alle Träger auf einer horizontalen Linie des Diagramms liegen und fehlerhafte I- oder Q-Werte als vertikale Striche oder ganz fehlende I/Q-Werte als Lücken in den horizontalen Linien sichtbar werden.

3. Verfahren nach Anspruch 1 oder 2,
**dadurch gekennzeichnet,**
**daß** auf dem Bildschirm jeweils nur ein Ausschnitt des insgesamt durch das Multiträgersystem belegten Frequenzbandes dargestellt wird.

4. Verfahren nach einem der vorhergehenden Ansprüche,
**dadurch gekennzeichnet,**
**daß** die Integration und Linienprojektion der durch komplexe Demodulation der einzelnen Träger gewonnenen I- und Q-Werte der einzelnen Symbole in einem Matrixspeicher erfolgt, der in seiner einen Dimension soviel Zeilenadressen hat wie für die verwendete Kodierung I- und Q-Werte vorhanden sind und der in seiner anderen Dimension soviel Spaltenadressen hat, wie Einzelträger bzw. aus nebeneinanderliegenden Trägern zusammengefaßte Trägergruppen vorhanden sind, wobei nacheinander jeder Träger bzw. jede Trägergruppe in der den jeweiligen I- und Q-Werten entsprechenden Zeilenadressen der zugehörigen Spaltenadressen jeweils ein Haltewert eingeschrieben wird, und nach Auswertung einer vorbestimmten Anzahl von Symbolen der Inhalt des Matrixspeichers für jede Spaltenadresse zur graphischen Darstellung auf der Anzeigeeinrichtung ausgelesen wird.

5. Verfahren nach Anspruch 4,
**dadurch gekennzeichnet,**
**daß** nach dem Auslesen des Matrixspeichers der Inhalt aller Adressen des Matrixspeichers um 1 dekrementiert wird.

## Claims

1. Method for measuring and evaluating multi-carrier signals,
**characterised in that**
the I and/or Q components which have been obtained by means of demodulation are integrated over a plurality of values and are represented graphically on the screen of a display device for each individual carrier or combined carrier group of the multi-carrier signal, the individual carriers or carrier groups being plotted side by side on the horizontal axis of a diagram and the I and/or Q components associated with these carriers or carrier groups being displayed respectively along a vertical line.

2. Method according to claim 1,
**characterised in that**
the I and Q components associated with each individual carrier or carrier group are projected upon a single vertical line, so that the I and Q components for all carriers lie on one horizontal line of the diagram and incorrect I or Q values become visible as vertical dashes or completely missing I/Q values as gaps in the horizontal lines.

3. Method according to claim 1 or 2,
**characterised in that**,
on the screen, only one section respectively of the frequency band which is occupied in total by the multi-carrier system is represented.

4. Method according to one of the preceding claims,
**characterised in that**
the integration and line projection of the I and Q values of the individual symbols, which values have been obtained by complex demodulation of the individual carriers, is effected in a matrix memory, which has as many line addresses in its one dimension as there are I and Q values for the used coding and which has as many column addresses in its other dimension as there are individual carriers or carrier groups combined from adjacently situated carriers, in succession, one retaining value respectively being written-in in the line addresses of the associated column addresses, which line addresses correspond to the respective I and Q values of each carrier or each carrier group, and after evaluation of a predetermined number of symbols, the content of the matrix memory being read out for each column address for graphic representation on the display device.

5. Method according to claim 4,
**characterised in that**,
after the reading-out of the matrix memory, the content of all addresses of the matrix memory is decremented by 1.

## Revendications

1. Procédé pour l'analyse par des appareils de mesure de signaux à porteuses multiples,
**caractérisé en ce que**
les composants I et/ou Q obtenus par démodulation sont intégrés pour plusieurs valeurs et représentés graphiquement pour chaque porteuse individuelle ou un groupe de porteuses regroupées du signal à porteuses multiples sur l'écran d'un dispositif d'affichage par le fait que les différentes porteuses ou groupes de porteuses sont reportés les uns à côté des autres sur l'axe horizontal d'un diagramme et les composants I et/ou Q correspondant à ces porteuses ou groupes de porteuses sont enregistrés respectivement le long d'une ligne verticale.

2. Procédé selon la revendication 1,
**caractérisé en ce que**
les composants I et Q correspondant à chaque porteuse individuelle ou chaque groupe de porteuses sont projetés sur une ligne verticale unique, de sorte que les composants I et Q pour toutes les porteuses sont disposés sur une ligne horizontale du diagramme et les valeurs I ou Q erronées sont visibles sous la forme de traits verticaux ou bien les valeurs I/Q complètement absentes sous la forme de vides dans les lignes horizontales.

3. Procédé selon la revendication 1 ou 2,
**caractérisé en ce que**
à chaque fois seulement une partie de la bande de fréquence occupée globalement par le système à porteuses multiples est représentée à l'écran.

4. Procédé selon l'une quelconque des revendications précédentes,
**caractérisé en ce que**
l'intégration et la projection sur des lignes des valeurs I et Q, obtenues par démodulation complexe des différentes porteuses, des différents symboles s'effectuent dans une mémoire matricielle qui présente dans l'une de ses dimensions autant d'adresses de ligne que de valeurs I et Q pour le codage utilisé et qui, dans son autre dimension, a autant d'adresses de colonne que de porteuses individuelles ou de groupes de porteuses constitués de porteuses juxtaposées, moyennant quoi une valeur de maintien est inscrite successivement pour chaque porteuse ou chaque groupe de porteuses dans les adresses de ligne, correspondant aux valeurs I et Q respectives, des adresses de colonne respectives et après l'analyse d'un nombre prédéfini de symboles, le contenu de la mémoire matricielle est sorti pour chaque adresse en colonne pour la représentation graphique sur l'appareil d'affichage.

5. Procédé selon la revendication 4,
**caractérisé en ce que**
après la lecture de la mémoire matricielle, le contenu de toutes les adresses de la mémoire matricielle est décrémenté de 1.
